Europäisches Patentamt

European Patent Office

Office européen des brevets

(11) Publication number: **0 234 741 B1**

# EUROPEAN PATENT SPECIFICATION

(45) Date of publication of patent specification: **19.08.92**

(51) Int. Cl.5: **H01L 27/10**

(21) Application number: **87300681.1**

(22) Date of filing: **27.01.87**

(54) Semiconductor memory device.

(30) Priority: **30.01.86 JP 20615/86**

(43) Date of publication of application:
**02.09.87 Bulletin 87/36**

(45) Publication of the grant of the patent:
**19.08.92 Bulletin 92/34**

(84) Designated Contracting States:
**DE FR GB**

(56) References cited:
**EP-A- 0 181 162**
**US-A- 4 044 340**
**US-A- 4 197 554**

**IEEE INTERNATIONAL SOLID-STATE CIR-CUITS CONFERENCE, DIGEST OF TECHNICAL PAPERS, Pennsylvania, February 1985, first edition, pages 244-245,355, IEEE; F. HORIGUCHI et al.: "A 1Mb DRAM with a fol-ded capacitor cell structure"**

**PATENT ABSTRACTS OF JAPAN, vol. 8, no. 221 (E-271)[1658], 9th October 1984; & JP-A-59 104 156**

(73) Proprietor: **MITSUBISHI DENKI KABUSHIKI KAISHA**
**2-3, Marunouchi 2-chome Chiyoda-ku Tokyo 100(JP)**

(72) Inventor: **Arimoto, Kazutami Mitsubishi-Denki K.K.**
**LSI Kenkyusho 1 Mizuhara 4-chome Itami-shi Hyogo-ken(JP)**
Inventor: **Mashiko, Koichiro Mitsubishi-Denki K.K.**
**LSI Kenkyusho 1 Mizuhara 4-chome Itami-shi Hyogo-ken(JP)**
Inventor: **Furutani, Kiyohiro Mitsubishi-Denki K.K.**
**LSI Kenkyusho 1 Mizuhara 4-chome Itami-shi Hyogo-ken(JP)**

(74) Representative: **Beresford, Keith Denis Lewis et al**
**BERESFORD & Co. 2-5 Warwick Court High Holborn**
**London WC1R 5DJ(GB)**

## Description

The present invention relates to a semiconductor memory device, and more particularly, it relates to a memory cell structure in a semiconductor memory device with a folded bit line structure suitable for high integration.

More specifically the present invention relates to a semiconductor memory device which is of that type comprising:

a substrate;

a multiplicity of word-lines;

a multiplicity of bit-lines isolated from and arranged to intersect with the multiplicity of word-lines, which bit-lines are paired and are arranged as part of a folded bit-line memory structure; and

a multiplicity of memory cells, each located at an intersection of a word-line and a bit-line and each comprised of a capacitor and a field-effect transistor which is defined in the substrate and connects the capacitor to a corresponding one of the bit-lines; wherein

each memory cell is isolated from its neighbours by means of an insulative structure including insulator lined grooving that is adjacent to and extends around each capacitor; and

each capacitor has a portion ($C_P$) that is merged with the insulator lined grooving.

Conventionally, various memory cell structures have been proposed and put into practice for achieving high integration of a semiconductor memory device. For example, a memory cell structure is known in which adjacent memory cells are isolated by a groove region and the side walls of the groove region are utilised as a capacitor for storing information.

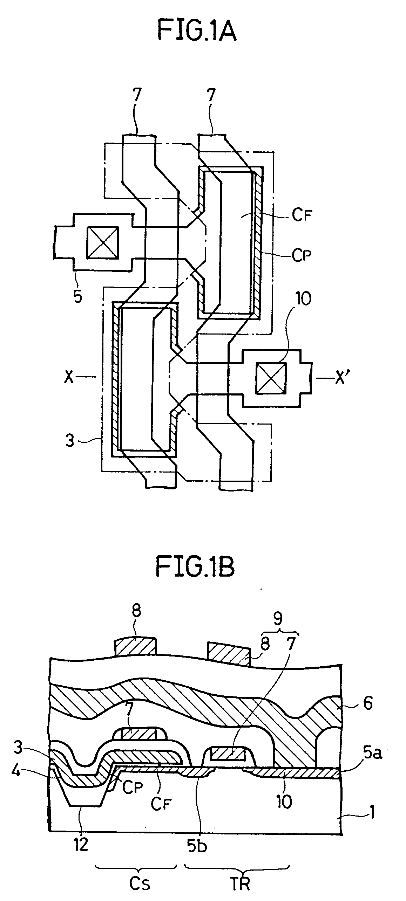

Figs. 1A and 1B are diagrams showing a structure of a conventional highly integrated dynamic semiconductor memory device, where Fig. 1A is a top sectional view thereof, and Fig. 1B is a cross sectional view taken along a line X-X' in Fig. 1A. The conventional dynamic memory device as shown is disclosed in an article by F. Horiguchi et al., entitled "1 Mb DRAM with Folded Capacitor Cell Structure", ISSCC85 Digest of Technical Papers, Feb., 1985, pp. 244-245.

A memory cell comprises a capacitor portion $C_S$ for storing information in the form of charges and a transistor TR for transferring information to and from the capacitor portion $C_S$. A groove isolation region 12 is formed around the memory cell. The groove region 12 is filled with oxide 2 serving as an insulator. Adjacent cells are elecrically isolated by the oxide 2.

The transistor TR comprises $n^+$-type diffusion regions 5a and 5b formed in a predetermined region of the p-type semiconductor substrate 1 and serving as a source and a drain, and a polysilicon (polycrystalline silicon) layer 7 formed on the $p^+$-type semiconductor substrate 1 between the diffusion regions 5a and 5b through a thin insulator film (gate dielectric film) and serving as a gate electrode.

The capacitor portion $C_S$ comprises a polysilicon layer 3 serving as a cell plate electrode, an $n^+$-type diffusion region 5b serving as the other electrode, and a capacitor dielectric film 4 serving as a dielectric between these layers. The diffusion region 5b is also formed in the portion along the side walls of the groove 12. The polysilicon layer 3 is formed so as to extend over and beyond the groove 12. Thus, the capacitor portion $C_S$ comprises capacitance $C_F$ formed of the diffusion region 5b and the polysilicon layer 3 in a flat portion, and capacitance $C_P$ formed of the diffusion region 5b and the polysilicon layer 3 on the side walls of the groove isolation region 12.

The $n^+$-type diffusion region 5a of the transistor TR is connected to a first aluminium interconnection layer 6 serving as a bit line through a contact hole 10. The gate electrode for turning the transistor TR on/off serves as a part of a word line 9. The word line 9 comprises the polysilicon layer 7 and a second aluminium interconnection layer 8. The polysilicon layer 7 and the second aluminium interconnection layer 8 are electrically connected at a constant pitch, whereby the word line 9 is reduced in resistance.

In the foregoing, since the side walls of the groove isolation region 12 provided along the outer peripheral portion of the memory cell are utilised as capacitance $C_P$, sufficiently wide operating margin and sufficient alpha particle immunity are ensured due to capacitance $C_P$, even if the chip area and the cell size are reduced so that capacitance $C_S$ in the flat portion is reduced. The longer the peripheral length of the memory cell to be utilised is, the shallower the groove for obtaining the same quantity of capacitance $C_P$ can be.

The disclosed device has a folded bit line structure as also is evident from the following figures of the present drawings.

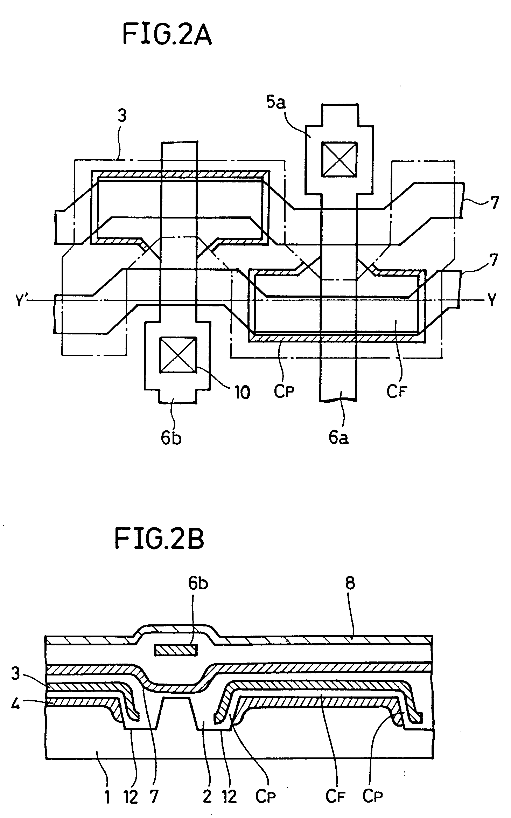

Figs. 2A and 2B are diagrams showing a structure of this same memory cell, where Fig. 2A is a plan view thereof and Fig. 2B is a cross sectional view taken along a line Y-Y' in Figs. 2A. Portions corresponding to those in Figs. 1A and 1B have the same reference numerals in Figs. 2A and 2B. In this structure, bit lines 6a and 6b comprising the first aluminium interconnection layer constitute a pair of complementary bit lines. The groove isolation region 12 is formed on both sides of a channel region 11 of the transistor $T_R$, whereby the channel region 11 is isolated from a capacitor portion of an adjacent memory cell. The polysilicon layer 3 serving as a cell plate extends into the groove isolation region 12.

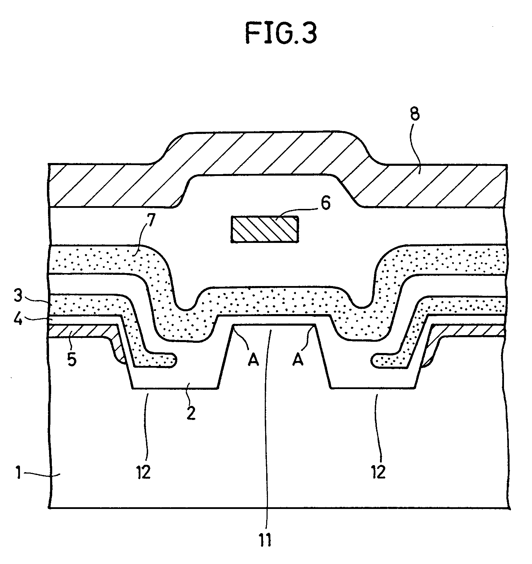

Fig. 3 is an enlarged cross sectional view in the neighborhood of the groove isolation region in Fig. 2A. As obvious from Fig. 3, the channel region 11 of the transistor TR is isolated from the capacitor portion of an adjacent memory cell by the groove isolation region 12. However, since a p-type diffusion layer serving as a channel stopper is not formed on the semiconductor substrate 1 in the groove isolation region 12, an inversion layer is liable to be formed in this portion. As a result, a leakage current flows from an edge portion A of the channel region 11 through the inversion layer. In addition, the polysilicon layer 3 serving as the cell plate must be terminated within the groove isolation region 12. Thus, if the groove isolation region 12 is formed with a minimum pattern width, it is difficult to perform the etching so as to terminate the polysilicon layer 3 within the isolation region 12. Furthermore, since the channel region 11 is in contact with the groove region 12, the step in this portion is increased, so that it becomes difficult to pattern the polysilicon layer 7 serving as a word line and being formed to extend over and beyond the channel region 11 and the groove isolation region 12. In order to avoid this, it is necessary to improve the proces of filling the groove isolation region 12 with insulator material.

A mention is also made of US Patent No. 4044340 which likewise discloses a semiconductor memory device which has a folded bit-line configuration. The memory cells disclosed are arranged one-by-one, in pairs or in fours, which are connected alternately to one bit-line and to its complement. No details concerning memory cell isolation are given.

It is also noted that European Patent Application No. 0181162 discloses a semiconductor memory device which uses trench isolation and includes isolation merged capacitance formed with the trench isolation. The structure is one of open bit line and not folded bit-line structure. Thick oxide film is embedded at the base of grooving and this grooving is provided immediately adjacent to each side of the channels of the charge transfer transistors employed in each memory cell. The problems of this aspect of the structure, in particular, the inherent problems of current leakage and conductor coverage, have already been mentioned above.

The present invention is intended as a solution to the problems described above. It is also intended to provide a semiconductor memory device which can be produced by a process in which etching of the polysilicon layer serving as the cell plate need not be a critical step of the process.

In accordance with the present invention there is provided a semiconductor memory device which is of that type already defined and which further is characterised in that

the insulative structure also includes field oxide insulator members, which members are shallow by comparison with the insulator lined grooving, and extend in a longitudinal direction along the lateral side edges of each side of the channel region of each of the field-effect transistors.

Since a field oxide insulator member is formed on each side of each of the channel regions, it is possible to constrain the leakage current in each channel region. The leakage current is in fact constrained to an extent that is typical of a conventional local oxidation isolated (LOCOS) structure. Also a step height reduction can be achieved with a consequent improvement in reliability and yield.

In this structure, the conductive layer serving as the cell plate need not terminate in the groove isolation region. The patterning thereof is thus not critical and processing can be simplified.

These and other features and advantages of the present invention will become apparent from the appended claims and also from the following detailed description of the preferred embodiments when taken in conjunction with the accompanying drawings in which:

Fig. 1A is a plan view showing a structure of a conventional semiconductor memory device;

Fig. 1B is a cross sectional view taken along a line X-X' in Fig. 1A;

Fig. 2A is a plan view of this same conventional semiconductor memory device and shows its folded bit line structure;

Fig. 2B is a cross sectional view taken along a line Y-Y' in Fig. 2A;

Fig. 3 is a partially enlarged view of Fig. 2B;

Fig. 4A is a plan view showing a structure of a semiconductor memory device according to an embodiment of the present invention;

Fig. 4B is a cross sectional view taken along a line X-X' in Fig. 4A;

Fig. 4C is a cross sectional view taken along a line Y-Y' in Fig. 4A;

Fig. 5A is a plan view showing a structure of a semiconductor memory device according to another embodiment of the present invention; and

Fig. 5B is a cross sectional view taken along a line X-X' in Fig. 5A.

So that this invention can be better understood, preferred embodiments thereof will now be described in detail. The description that follows is given by way of example only.

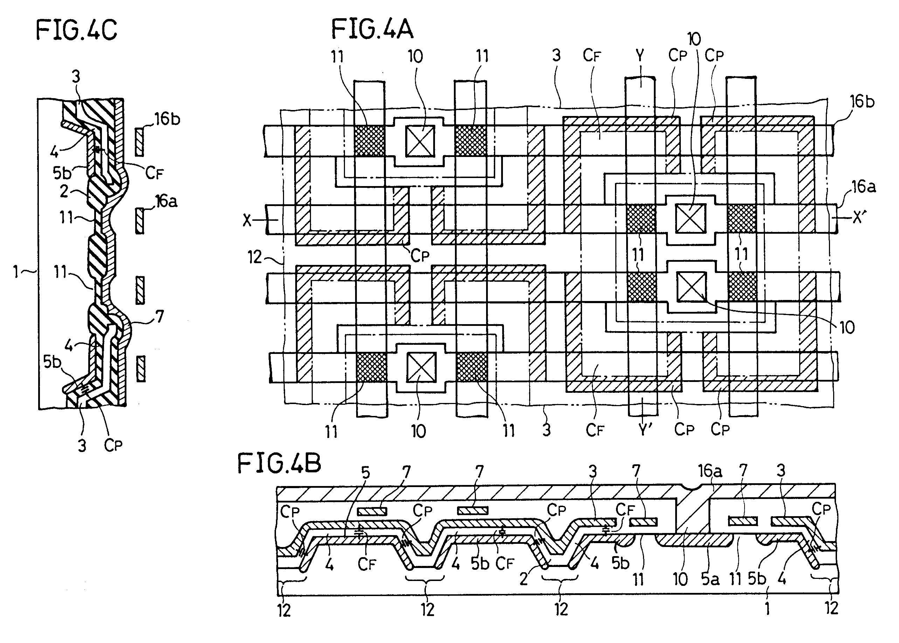

Figs. 4A, 4B and 4C are diagrams showing a structure of a semiconductor memory device embodying the present invention, where Fig. 4A is a plan view thereof, Fig. 4B is a cross sectional view taken along a line X-X' in Fig. 4A and Fig. 4C is a cross sectional view taken along a line Y-Y' in Fig. 4A. Portions identical or corresponding to those in Fig. 2A and 2B have identical reference numerals in Figs. 4A to 4C.

A single memory cell is formed in a U shape. A thick field oxide film 2 is formed on both sides of the channel region 11 of a transistor. A channel region 11 and a capacitor portion $C_F$ are isolated by the field oxide film 2 (Figs. 4A and 4C). Capacitors of memory cells connected to a first aluminium interconnection layer 16a (or 16b) serving as a bit line are isolated from each other by a groove isolation region 12. A first polysilicon layer 3 serving as a cell plate is formed to extend over and beyond the groove isolation region 12, and is shared with adjacent memory cells. The first aluminium interconnection layer 16a (or 16b) serving as a bit line is connected to two memory cells through a contact hole 10. A pair of the first aluminium interconnection layers 16a and 16b constitute a pair of complementary bit lines.

As obvious from the plan view of Fig. 4A, the polysilicon layer 3 can be shared with adjacent memory cells. During patterning (etching) it is not required to terminate the polysilicon layer 3 in the groove isolation region 12. Accordingly, the manufacturing process is not so critical and therefore can be simplified.

In addition, since the groove isolation region 12 does not come into contact with the channel region 11, the channel region 11 does not have an edge discontinuity, so that the leakage current in the transistors is easily constrained and the holding characteristics of charges as information are not degraded. Furthermore, the step in side ends of the channel region 11 is reduced, so that the patterning of the polysilicon layer 7 also is simplified.

Furthermore, since this structure can make the best use of the side walls of the groove isolation region 12, more capacitance for storing charges as information can be obtained, as compared with a conventional structure. For example, in order to obtain capacitance of 50 fF if the thickness of a capacitor insulating 10 nm film (100 Å) in design rule, the depth of the groove isolation region 12 may be approximately 2 um if the cell area is 10 um², so that the manufacturing process again can be simplified.

Although in the above described embodiment, the capacitor electrodes are formed of a polysilicon layer 3 and an n⁺-type diffusion region 5b, other combinations are possible. For example, if polysilicon is used in place of the diffusion, a memory cell structure immune to radioactive rays such as alpha rays can be obtained.

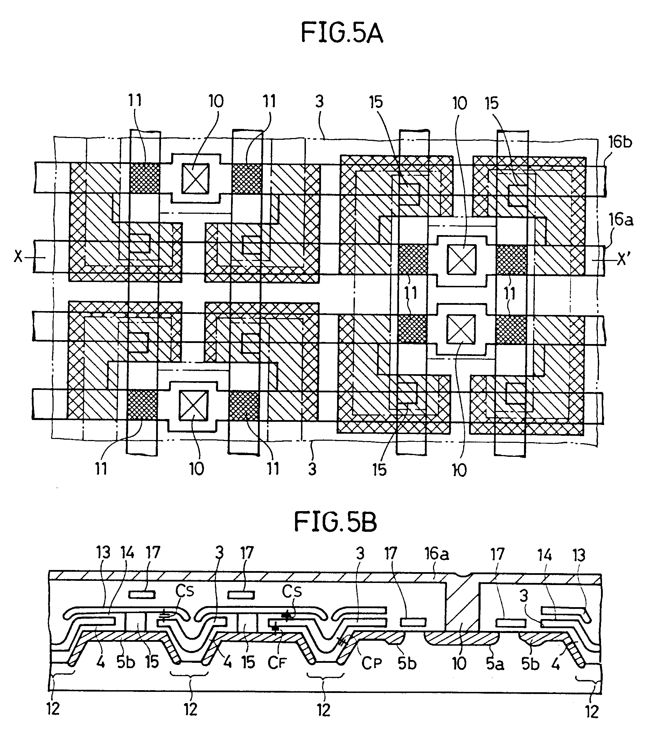

Figs. 5A and 5B are diagrams showing a structure of a semiconductor memory device according to another embodiment of the present invention, where Fig. 5A is a plan view thereof, and Fig. 5B is a cross sectional view taken along a line X-X' in Fig. 5A. Portions identical or corresponding to those in Figs. 4A and 4B have identical reference numerals in Figs. 5A and 5B. In the structure shown in Figs. 5A and 5B, a polysilicon layer 13 is formed on the polysilicon layer 3 and over an insulating film 14 to overlap with the polysilicon layer 3 at least in a flat region. The polysilicon layer 13 is electrically connected to the n⁺-type diffusion region 5b directly by a contact 15. A polysilicon layer 17 serving as a word line is provided to extend over and beyond the polysilicon layer 13. The polysilicon layer 17 constitutes a gate electrode of the transistor.

In the above described structure, additional capacitance $C_S$ is formed between the polysilicon layer 13 and the polysilicon layer 3. Thus, capacitance $C_S$ for storing charges as information comprising the polysilicon layer 3 and the polysilicon layer 13 is added to capacitance $C_P$ for storing charges as information comprising the polysilicon layer 3 and the diffusion layer 5b, so that larger capacitance for storing charges as information can be obtained.

Although the present invention has been described and illustrated in detail, it is clearly understood that the same is by way of illustration and example only and is not to be taken by way of limitation, the scope of the present invention being limited only by the terms of the appended claims.

**Claims**

1. A semiconductor memory device comprising:
   a substrate (1);
   a multiplicity of word-lines (7);
   a multiplicity of bit-lines (16a, 16b) isolated from and arranged to intersect with said multiplicity of word-lines (7), which bit-lines are paired (16a & 16b) and are arranged as part of a folded bit-line memory structure; and
   a multiplicity of memory cells, each located at an intersection of a word-line (7) and a bit-line (16a, 16b), and each comprised of a capacitor (5b & 3) and a field-effect transistor (5a, 5b, 11 & 7) which is defined in said substrate (1) and connects said capacitor (5b & 3) to a corresponding one of said bit-lines (16a, 16b); wherein
   each memory cell is isolated from its neighbours by means of an insulative structure including insulator lined grooving (12) that is adjacent to and extends around each capacitor (5b & 3); and
   each capacitor (5b & 3) has a portion ($C_P$) that is merged with said insulator lined grooving (12);
   which semiconductor memory device is characterised in that:
said insulative structure also includes field oxide insulator members (2), which members are shallow by comparison with said insulator lined grooving (12), and extend in a longitudinal direction along the lateral side edges of each side of the channel region (11) of each of said field-effect transistors (5a, 5b, 11, 7).

2. A device as claimed in claim 1 wherein each capacitor (5b & 3) has an electrode structure comprising:
an individual diffused electrode formed by a dopant diffused region (5b) of said substrate (1) which is located at a principal surface of said substrate (1) and at a sidewall surface which is co-extensible therewith and which is adjacent to said insulator lined grooving (12); and
a common plate electrode (3) spaced from and overlying said individual electrode (5b) to define them, a capacitor having both a principal surface portion ($C_F$) and a portion ($C_P$) that is merged with said insulator lined grooving (12).

3. A device, as claimed in claim 2, wherein the electrode structure of each capacitor (5b & 13) further comprises an individual plate electrode (13) spaced from and overlying said common plate electrode (3), which individual plate electrode (13) is electrically connected to said individual diffused electrode (5b) by means of an interconnect (15) that passes through and is isolated from said common plate electrode (3).

4. A device as claimed in either of claims 2 & 3 wherein in the electrode structure of each capacitor (5b & 13) that portion of said diffused region (5b) of said substrate (1) which is located at the sidewall surface of said substrate (1) extends to the bottom of said insulator lined grooving (12), and said common plate electrode (3) reaches towards said bottom to overlap substantially the whole of said individual diffused electrode (5b).

5. A device as claimed in any one of the preceding claims 2 to 4 wherein said common plate electrode (3) reaches into said insulator lined grooving (12), is continuous, and overlies the sidewall surfaces of the substrate (1) to each side of the insulator lined grooving (12).

6. A device as claimed in any one of the preceding claims wherein the memory cells connected to each pair of paired bit-lines (16a, 16b) are connected in pairs alternately to one bit-line (16a) and to the other bit-line (16b).

7. A device as claimed in claim 6 wherein said pairs of memory cells connected to the one bit-line (16a) of one pair of paired bit-lines (16a, 16b) are located adjacent to the pairs of memory cells connected to the other bit-line (16b) of an adjacent pair of paired bit-lines (16a, 16b) and are separated therefrom by respective ones of said field oxide insulator members (2), each adjacent two pairs of memory cells being entirely surrounded by said insulator-lined grooving (12).

8. A device as claimed in any one of the preceding claims wherein the capacitor (5b & 3) of each memory cell has first and second regions respectively overlapped by one and the other bit-line of a pair of the paired bit-lines (16a, 16b) and a third region integral therewith, said first, second and third regions of said capacitor defining the uprights and the base of a U-shaped structure, which U-shaped structure is formed about one of the two field oxide insulator members (2) each side of the channel region (11) of the memory cell transistor (5a, 5b, 11 & 7), one of said uprights of the U-shape being adjacent also to the other one of the two field oxide insulator members (2), and the remaining sides of the U-shaped structure being surrounded by and merged with the insulator-lined grooving (12).

**Patentansprüche**

1. Halbleiterspeichereinrichtung mit
einem Substrat (1);
einer Vielzahl von Wortleitungen (7);
einer von der Vielzahl von Wortleitungen (7) isolierten und zum Kreuzen der Vielzahl von Wortleitungen (7) angeordneten Vielzahl von Bitleitungen (16a, 16b), die gepaart (16a & 16b) und als Teil einer gefalteten Bitleitungsspeicherstruktur angeordnet sind; und
einer Vielzahl von Speicherzellen, von denen jede an einer Kreuzung einer Wortleitung (7) und einer Bitleitung (16a, 16b) angeordnet ist und von denen jede einen Kondensator (5b & 3) und einen Feldeffekttransistor (5a, 5b, 11 & 7) aufweist, der in dem Substrat (1) definiert ist, und den Kondensator (5b & 3) mit einer entsprechenden der Bitleitungen (16a, 16b) verbindet;
wobei jede Speicherzelle von ihren Nachbarn mittels einer isolierenden Struktur einschließlich einer ausgekleideten Isolatorrille (12) isoliert ist, die benachbart zu jedem Kondensator (5b & 3) ist und sich um ihn herum erstreckt;

und jeder Kondensator einen Abschnitt ($C_P$) aufweist, der mit der ausgekleideten Isolatorrille (12) verbunden ist;

dadurch gekennzeichnet,

daß die isolierende Struktur ebenfalls Feldoxidisolatorteile (2) aufweist, die flach sind im Vergleich mit der ausgekleideten Isolatorrille (12) und sich in eine Längsrichtung entlang der seitlichen Seitenkanten von jeder Seite des Kanalbereiches (11) von jedem der Feldeffekttransistoren (5a, 5b, 11, 7) erstreckt.

2. Einrichtung nach Anspruch 1, bei der jeder Kondensator (5b & 3) eine Elektrodenstruktur aufweist, mit:

einer individuellen diffundierten Elektrode, die durch einen diffundierten Dotiermittelbereich (5b) des Substrates (1) gebildet ist, der an einer Hauptoberfläche des Substrates (1) und an einer Seitenwandoberfläche angeordnet ist, die sich damit zusammen erstreckt und benachbart zu der ausgekleideten Isolatorrille (12) vorgesehen ist; und

einer gemeinsamen Plattenelektrode (3), die in einem Abstand von der individuellen Elektrode (5b) und darüber angeordnet ist, um sie zu definieren, wobei ein Kondensator sowohl einen Hauptoberflächenabschnitt ($C_F$) und einen Abschnitt ($C_P$) aufweist, der mit der ausgekleideten Isolatorrille (12) verschmolzen ist.

3. Einrichtung nach Anspruch 2, bei der die Elektrodenstruktur von jedem Kondensator (5b & 13) weiter eine individuelle Plattenelektrode (13) aufweist, die in einem Abstand von der gemeinsamen Plattenelektrode (3) angeordnet ist und darüber liegt, wobei die individuelle Plattenelektrode (13) elektrisch mit der individuellen diffundierten Elektrode (5b) mittels einer Verbindung (15) so verbunden ist, daß sie durch die gemeinsame Plattenelektrode (3) geht und von ihr isoliert ist.

4. Einrichtung nach Anspruch 2 oder 3, bei der bei der Elektrodenstruktur von jedem Kondensator (5b & 13) der Abschnitt des diffundierten Bereiches (5b) des Substrates (1), der an der Seitenwandoberfläche des Substrates (1) angeordnet ist, sich zu dem Boden der ausgekleideten Isolatorrille (12) erstreckt und die gemeinsame Plattenelektrode (3) bis zu dem Boden zum im wesentlichen Überlappen der gesamten individuellen diffundierten Elektrode (5b) reicht.

5. Einrichtung nach einem der vorhergehenden Ansprüche 2 bis 4, bei der die gemeinsame Plattenelektrode (3) in die ausgekleidete Isolatorrille (12) reicht, sich kontinuierlich erstreckt und über den Seitenwandoberflächen des Substrates (1) auf jeder Seite der ausgekleideten Isolatorrille (12) liegt.

6. Einrichtung nach einem der vorhergehenden Ansprüche, bei der die Speicherzellen, die mit jedem Paar von gepaarten Bitleitungen (16a, 16b) in Paaren abwechselnd mit einer Bitleitung (16a) und der anderen Bitleitung (16b) verbunden sind.

7. Einrichtung nach Anspruch 6, bei der die Paare von Speicherzellen, die mit der einen Bitleitung (16a) eines Paares von gepaarten Bitleitungen (16a, 16b) verbunden sind, benachbart zu den Paaren von Speicherzellen angeordnet sind, die mit der anderen Bitleitung (16b) eines benachbarten Paares von gepaarten Bitleitungen (16a, 16b) verbunden sind, und davon durch entsprechende der Feldoxidisolatorteile (2) getrennt sind, wobei jede benachbarten zwei Paare von Speicherzellen ganz von der ausgekleideten Isolatorrille (12) umgeben sind.

8. Einrichtung nach einem der vorhergehenden Ansprüche, bei der der Kondensator (5b & 3) einer jeden Speicherzelle einen ersten bzw. zweiten Bereich aufweist, die von der einen und der anderen Bitleitung eines Paares von den gepaarten Bitleitungen (16a, 16b) überlappt werden, und einen einstückig damit gebildeten dritten Bereich, wobei der erste, zweite und dritte Bereich des Kondensators die aufrechten Teile und die Basis einer U-förmigen Struktur definieren, wobei die U-förmige Struktur um eines der zwei Feldoxidisolatorteile (2) jeder Seite des Kanalbereiches (11) des Speicherzellentransistors (5a, 5b, 11 & 7) gebildet ist, eines der aufrechten Teile der U-Form benachbart ebenfalls zu dem anderen der zwei Feldoxidisolatorteile (2) vorgesehen ist und die verbleibenden Seiten der U-förmigen Struktur von der ausgekleideten Isolatorrille (12) umgeben sind und damit verschmolzen sind.

## Revendications

1. Un dispositif de mémoire à semiconducteurs comprenant :

un substrat (1);

un ensemble de lignes de mot (7);

un ensemble de lignes de bit (16a, 16b), isolées vis-à-vis de l'ensemble de lignes de mot (7), et disposées de façon à former des intersections avec ces dernières, ces lignes de bit étant associées par paires (16a et 16b) et constituant une partie d'une structure de mémoire à lignes de bit repliées; et

un ensemble de cellules de mémoire, chacune d'elles étant placée à une intersection d'une ligne de mot (7) et d'une ligne de bit (16a, 16b), et chacune d'elles comprenant un condensateur (5b et 3) et un transistor à effet de champ (5a, 5b, 11 et 7) qui est défini dans le substrat (1) et qui connecte le condensateur (5b et 3) à l'une correspondante des lignes de bit (16a, 16b); dans lequel

chaque cellule de mémoire est isolée de ses voisines au moyen d'une structure isolante comprenant un sillon (12) revêtu d'un isolant, qui est adjacent à chaque condensateur (5b et 3) et qui s'étend autour de ce dernier; et

chaque condensateur (5b et 3) comporte une partie ($C_P$) qui est une partie intégrante du sillon (12) revêtu d'isolant;

ce dispositif de mémoire à semiconducteurs étant caractérisé en ce que :

la structure isolante comprend également des éléments isolants en oxyde de champ (2) qui ont une faible profondeur en comparaison avec le sillon (12) revêtu d'isolant, et qui s'étendent dans une direction longitudinale le long de chacun des bords latéraux de la région de canal (11) de chacun des transistors à effet de champ (5a, 5b, 11, 7).

2. Un dispositif selon la revendication 1, dans lequel chaque condensateur (5b et 3) a une structure d'électrodes comprenant :

une électrode diffusée individuelle, formée par une région diffusée de dopant (5b) du substrat (1), qui se trouve sur une surface principale du substrat (1) et dans une surface de paroi latérale s'étendant sur la même longueur, et qui est adjacente au sillon (12) revêtu d'isolant; et

une électrode commune de type métallisation (3), espacée par rapport à l'électrode individuelle (5b) et recouvrant cette dernière, pour définir avec elle un condensateur ayant à la fois une partie de surface principale ($C_F$) et une partie ($C_P$) qui fait partie intégrante du sillon (12) revêtu d'isolant.

3. Un dispositif selon la revendication 2, dans lequel la structure d'électrodes de chaque condensateur (5b et 13) comprend en outre une électrode individuelle de type métallisation (13) qui est espacée par rapport à l'électrode commune de type métallisation (3) et qui recouvre cette dernière, cette électrode individuelle de type métallisation (13) étant connectée électriquement à l'électrode diffusée individuelle (5b) au moyen d'une interconnexion (15) qui traverse l'électrode commune de type métallisation (3) et qui est isolée vis-à-vis de cette dernière.

4. Un dispositif selon l'une quelconque des revendications 2 ou 3, dans lequel, dans la structure d'électrodes de chaque condensateur (5b et 13), la partie de la région diffusée (5b) du substrat (1) qui se trouve sur la surface de paroi latérale du substrat (1) s'étend jusqu'au fond du sillon (12) revêtu d'isolant, et l'électrode commune de type métallisation (3) s'étend jusqu'à proximité du fond de façon à recouvrir pratiquement la totalité de l'électrode diffusée individuelle (5b).

5. Un dispositif selon l'une quelconque des revendications 2 à 4 précédentes, dans lequel l'électrode commune de type métallisation (3) pénètre à l'intérieur du sillon (12) revêtu d'isolant, elle est continue et elle recouvre les surfaces de paroi latérale du substrat (1) sur chaque côté du sillon (12) revêtu d'isolant.

6. Un dispositif selon l'une quelconque des revendications précédentes, dans lequel les cellules de mémoire connectées à chaque paire de lignes de bit associées par paires (16a, 16b), sont connectées par paires alternativement à une ligne de bit (16a) et à l'autre ligne de bit (16b).

7. Un dispositif selon la revendication 6, dans lequel les paires de cellules de mémoire connectées à une première ligne de bit (16a) d'une paire de lignes de bit associées par paires (16a, 16b) sont placées de façon adjacente aux paires de cellules de mémoire connectées à l'autre ligne de bit (16b) d'une paire adjacente de lignes de bit associées par paires (16a, 16b), et elles sont séparées de ces dernières par des éléments respectifs parmi les éléments isolants en oxyde de champ (2), chaque groupe de deux paires de cellules de mémoire adjacentes étant entièrement entouré par le sillon (12) revêtu d'isolant.

8. Un dispositif selon l'une quelconque des revendications précédentes, dans lequel le condensateur (5b et 3) de chaque cellule de mémoire comporte des première et seconde régions qui sont respectivement recouvertes par l'une et l'autre des lignes de bit d'une paire de lignes de bit associées par paires (16a, 16b), et une troisième région formée d'un seul tenant avec elles, les première, seconde et troisième régions du condensateur définissant les parties verticales et la base d'une structure en forme de U, cette structure en forme de U étant formée autour de l'un des deux éléments isolants en oxyde de champ (2) de chaque côté de la région de canal (11) du transistor de cellule de mémoire (5a, 5b, 11 et 7), l'une des parties verticales de la forme en U étant également adjacente à l'autre des deux éléments isolants en oxyde de champ (2), et les côtés restants de la structure en forme de U étant entourés par le sillon (12) revêtu d'isolant et faisant partie intégrante de celui-ci.

## FIG.1A

## FIG.1B

## FIG.2A

## FIG.2B

# FIG.3

FIG.4A

FIG.4B

FIG.4C

# FIG.5A

# FIG.5B